# EUROPÄISCHE PATENTANMELDUNG

(11) **EP 2 980 823 A1**
(43) Veröffentlichungstag der Anmeldung: **03.02.2016**
(21) Anmeldenummer: 14179158.2
(22) Anmeldetag: 30.07.2014
(51) Int. Cl.: H01H 19/00, H05K 1/18

(54) **Drehkodierschalter**

(71) Anmelder: Siemens Aktiengesellschaft, 80333 München (DE)
(72) Erfinder: Bracke, Jennifer, 92696 Flossenbürg (DE); Schöpf, Heinz, 92224 Amberg (DE); Strobl, Michael, 92224 Amberg (DE)

(57) **Zusammenfassung**

Die Erfindung betrifft einen Drehkodierschalter mit einer Anzahl von Schaltstufen aufweisend ein Gehäuseoberteil (2) und ein Gehäuseunterteil (1).

Die Erfindung zeichnet sich dadurch aus, dass das Gehäuseunterteil (1) als Leiterplatten-Modul ausgebildet ist.

## Beschreibung

Die Erfindung betrifft einen Drehkodierschalter mit einer Anzahl von Schaltstufen, aufweisend ein Gehäuseoberteil und ein Gehäuseunterteil.

Drehkodierschalter werden überall da eingesetzt, wo mittels eines Schalters in einem Produkt ein Wert eingestellt werden muss, bei dessen Erreichung eine Aktion ausgelöst werden soll. So wird der 64-stufige Drehkodierschalter beispielsweise in Überlastrelais zur Einstellung des Auslösewertes bei einem Überlaststrom benötigt. Wird der voreingestellte Stromwert überschritten, löst das Überlastrelais aus und schützt somit zum Beispiel den Motor einer Anlage.

Ein Drehkodierschalter schaltet die ankommenden Signale vom gemeinsamen Kontakt auf die verschiedenen Ausgänge. Die Kodierung bestimmt, bei welcher Schaltstellung das Signal auf welche Ausgänge geschaltet ist.

Bisherige Drehkodierschalter sehen ein Kunststoffgehäuse vor, das aus zwei Halbschalen aufgebaut ist, in welchen Kalotten, also umspritzte metallische federnde Schleifkontakte, ein elektronisches Signal über eine Drehkodierscheibe abgreifen. Diese Scheibe ist unten mit einer metallischen Kulisse beschichtet, welche den jeweils eingesetzten Schaltcode umsetzt. Die Codeausgabe erfolgt über die Anschlusspins, die an einem Eco-Controller angeschlossen werden. Durch Drehbetätigung der Scheibe wird der Code von Position zu Position durchgeschaltet. Die bis zu 64-stufige Verrastung wird über ein Rastblech realisiert, welches die Riffelung am Rand der Kodierscheibe abgreift. Die Gehäuseschalen werden durch einen Gehäusebügel zusammengehalten, welcher auch auf der Leiterplatte zur Schalterfixierung verlötet wird.

Häufige Probleme treten durch die mangelhafte Koplanarität der Lötpins und Kalotten im Schaltinneren auf. Hinsichtlich des Zusammenspiels der Toleranzen und des Anpressdrucks, welcher durch den Metallkäfig entsteht, ist ein Drehkodierschalter generell sehr problemanfällig. Kommt es zu ungünstigen Verhältnissen, können Kontaktabheber im Inneren des Schalters zu Fehlfunktionen führen.

Demgemäß besteht die Aufgabe der vorliegenden Erfindung darin, einen Drehkodierschalter mit einer verbesserten Funktionalität zu schaffen.

Diese Aufgabe wird durch einen Drehkodierschalter mit den Merkmalen des Patentanspruchs 1 gelöst. Vorteilhafte Aus- und Weiterbildungen, welche einzeln oder in Kombination miteinander eingesetzt werden können, sind der Gegenstand der abhängigen Ansprüche.

Erfindungsgemäß wird diese Aufgabe durch einen Drehkodierschalter mit einer Anzahl von Schaltstufen gelöst, der ein Gehäuseoberteil und ein Gehäuseunterteil aufweist. Die Erfindung zeichnet sich dabei dadurch aus, dass das Gehäuseunterteil als Leiterplatten-Modul ausgebildet ist.

Der Kern der Erfindung besteht darin, die Funktionen der Gehäusehalbschalen in benachbarte, ohnehin vorhandene Bauteile zu verlagern. Dabei werden die Funktionen des mit eingespritzten Kalotten versehenen bisherigen Gehäuseunterteils ersetzt durch einen Verbund aus einer Leiterplatte mit Kontaktelementen und einer MID-Einheit (Molded Interconnect Device), in welcher die Funktionen Drehbetätigung, Kodier-Leiterbahn und Drehverrastung angeordnet sind. Hierfür werden in einem CAD-System (Computer Added Design) für Leiterplattenlayouts einmalig PCB (Printed Circuit Board)-Layout-Module für das Leiterplattendesign hinterlegt, welche alle Funktionen und damit Codes enthalten.

Zudem werden im Gehäuseoberteil Funktionen integriert, wie zum Beispiel die Abdeckfunktion, die Einbringung eines Labyrinths für Fremdstoffe, die Positionierung sowie die Verrastung. Hierfür werden einmalig im CAD-System Module für die Kunststoffteile-Konstruktion hinterlegt, die diese Funktionen beinhalten.

Für die Kodierung sind zwei Realisierungsmöglichkeiten denkbar: Zum Einen können auf der Leiterplatte aufgebrachte SMD-Kontaktelemente in Verbindung mit einer auf der Kodierscheibenunterseite aufgebrachten Kulisse miteinander die Kodierfunktion ergeben. Zum Anderen können auf der Kodierscheibenunterseite aufgebrachte eingespritzte Kontaktelemente in Verbindung mit einer auf der Leiterplatte als Leiterbahnstruktur aufgebrachten Kulisse die Kodierfunktion bilden. Die Kodierfunktion kann dabei jederzeit geändert werden ohne neue Bauteile zu benötigen.

Die Funktion für die mechanisch taktile Verrastung der Schaltstufen kann als Rastkugel, Raststift, Rastnase oder Ähnliches an der Zylinderaußenfläche oder an der Planfläche des Drehbetätigungsteils im Zusammenspiel mit der jeweils korrespondierenden Gegenfläche am Deckel beziehungsweise an der Leiterplatte umgesetzt werden. Es kann hier also eine preisgünstige Metall- oder Kunststoffkugel an Stelle eines teuren Metallbügels eingesetzt werden.

Erfindungsgemäß wird also zunächst in einem ersten Schritt die Funktionalität des Gehäuseunterteils des Drehkodierschalters mit eingebetteten Kontaktstiften als Leiterplatten-Layout-Modul entflochten und auf einer Leiterplatte platziert. Eventuell erforderliche Kontaktstellen auf der Leiterplatte können dabei durch geeignete SMD-Bestückungen realisiert werden. Dadurch kann das bisherige Gehäuseunterteil mit eingespritzten sieben Kontakt-Kalotten entfallen. Zudem werden die Kalotten durch SMD-Kontaktstücke ersetzt.

In einer besonders vorteilhaften Ausgestaltung der Erfindung kann es vorgesehen sein, dass die Bestückung des Leiterplatten-Moduls mit Kontaktstellen in Form von SMD-Elementen ausgebildet ist. Durch die Verwendung von SMD (Service Mounted Device)-Kontaktelementen wird der Fertigungsprozess für die Integration der Kontaktelemente erheblich vereinfacht, da diese Kontaktelemente als Oberflächen montierte Bauelemente ausgebildet sind.

In einer speziellen Ausgestaltung der Erfindung kann ein weiteres Konzept darin bestehen, dass das Gehäuseoberteil als Kunststoff-Spritzgieß-Modul ausgebildet ist mit einem Verrastprofil, um die unterschiedlichen Schaltstufen umzusetzen. Dabei übernimmt das Gehäuseoberteil die Funktion für die Abdeckung, die Integration eines Labyrinths für Fremdstoffe, die Positionierung sowie die Rastung des Drehkodierschalters. Die bisherige Verwendung des Gehäuseoberteils mit einem Rastblechbügel kann somit entfallen. Dieses spezielle Gehäuseoberteil kann Rechner unterstützt konstruiert werden (CAD-System).

In einer weiteren besonders vorteilhaften Ausführungsform der Erfindung kann es vorgesehen sein, dass das Verrastprofil in 5,625°-Schritten ausgebildet ist, um 64 Schaltstufen, elektrisch und taktil, umzusetzen. Durch die Rechner unterstützte Konstruktion für das Gehäuseoberteil ist es jedoch denkbar, auch entsprechend andere Verrastprofile umzusetzen.

In einer weiteren besonders vorteilhaften Ausführungsform der Erfindung kann es vorgesehen sein, dass im Gehäuseoberteil ein Labyrinth für Fremdstoffe angeordnet ist. Diese Schmutzlabyrinthe sind insbesondere auf der Seite des Betätigungsdoms sowie auch zur Leiterplatte hin angeordnet, um Schmutzeintritte möglichst zu vermeiden.

In einer speziellen Ausgestaltung der Erfindung kann ein weiteres Konzept darin bestehen, dass das Gehäuseoberteil zur sicheren Fixierung Zapfen aufweist. Diese Fixierzapfen sind insbesondere mit Tiefenanschlag ausgebildet zur präzisen Fixierung der Kodiereinheit in x-y-z-Richtung sowie zur Sicherung gegen Verdrehbewegungen.

Erfindungsgemäß kann es weiterhin vorgesehen sein, dass der Drehkodierschalter ein Betätigungselement aufweist, welches in MID-Technik ausgebildet ist. Im Betätigungselement sind ein Betätigungsschlitz sowie ein Richtungspfeil angeordnet. Zudem sind auf der Zylinder-Außenmantelfläche des Betätigungselements 64 Rastnuten positioniert. Auf der Unterseite des Betätigungselementes ist eine Kreiskulisse mit Gray-Kodierung aufgefräst. Dieses Bauteil wird gemäß der Erfindung nun als spritzgegossener Schaltungsträger (Moulded Interconnect Device) hergestellt.

Der erfindungsgemäße Drehkodierschalter mit einer Anzahl von Schaltstufen weist ein Gehäuseunterteil auf, welches als Leiterplatten-Modul (Printed Circuit Board) mit Kodierstruktur als festem Layout-Element ausgebildet ist. Der Drehkodierschalter weist zudem ein Gehäuseoberteil auf, welches als Kunststoff-Spritzgieß-Modul ausgebildet ist. Im Gehäuseoberteil ist ein Verrastprofil angeordnet, um die unterschiedlichen Schaltstufen umzusetzen. Das Verrastprofil ist dabei in 5,625°-Schritten ausgebildet, um vorzugsweise 64 Schaltstufen, elektrische und taktil, umzusetzen. Im Gehäuseoberteil ist zudem ein Labyrinth für Fremdstoffe in Form von Ausnehmungen angeordnet. Das Gehäuseoberteil weist außerdem Fixierzapfen auf, die in Durchbohrungen im Gehäuseunterteil fixiert sind und Verdrehbewegungen vermeiden. Zudem weist der Drehkodierschalter ein Betätigungselement auf, welches vorzugsweise in MID-Technik ausgebildet ist.

Der erfindungsgemäße Drehkodierschalter zeichnet sich durch eine Reduzierung der Einzelteilkomplexität aus, indem Einzelfunktionen in benachbarte, ohnehin vorhandene Bauteile verlagert werden, so dass die Anzahl der benötigten Einzelteile für den erfindungsgemäßen Drehkodierschalter reduziert werden konnte. Durch die Verwendung des CAD-Systems (Computer Added Design) können auf einfache Weise verschiedene Ausführungen mit anderen Kodierungen mit Abstufungen umgesetzt werden. Das hier vorgestellte Konzept ist sowohl für die stehende, als auch für die liegende Variante des Drehkodierschalters umsetzbar, wobei für die stehende Variante eine um 90° versetzte Zwischenplatine erforderlich ist. Durch das hier gewählte Design für die Kodiermatrix sind auch komplett neue Funktionen mit unterschiedlichen Kodierungen denkbar.

Weitere Vorteile und Ausführungen der Erfindung werden nachfolgend anhand von Ausführungsbeispielen sowie anhand der Zeichnung näher erläutert.

Dabei zeigen:
Fig. 1 in einer schematischen Darstellung einen erfindungsgemäßen Drehkodierschalter mit funktionalisiertem Gehäuseoberund -unterteil;
Fig. 2 in einer schematischen Darstellung das Betätigungselement sowie einen Teil des Gehäuseoberteils;
Fig. 3 in einer schematischen Darstellung das Gehäuseunterteil mit einem Teil des Gehäuseoberteils.

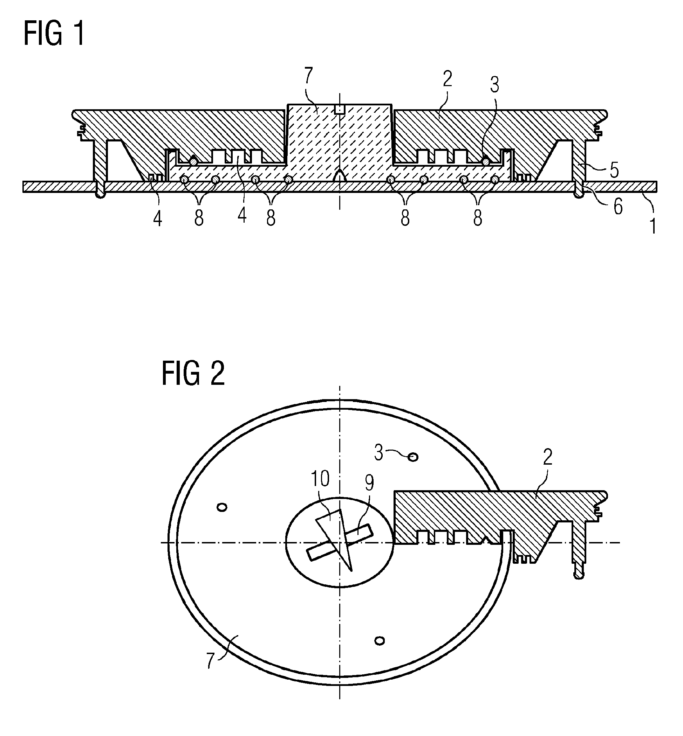

Fig. 1 zeigt einen erfindungsgemäßen Drehkodierschalter mit einer Anzahl von Schaltstufen, der ein Gehäuseunterteil 1 aufweist, welches als Leiterplatten-Modul (Printed Circuit Board) mit Kodierstruktur als festem Layout-Element ausgebildet ist. Der Drehkodierschalter weist zudem ein Gehäuseoberteil 2 auf, welches als Kunststoff-Spritzgieß-Modell ausgebildet ist. Im Gehäuseoberteil 2 ist ein Verrastprofil 3 angeordnet, um die unterschiedlichen Schaltstufen umzusetzen. Das Verrastprofil 3 ist dabei in 5,625°-Schritten ausgebildet, um vorzugsweise 64 Schaltstufen, elektrisch und taktil, umzusetzen. Im Gehäuseoberteil 2 ist zudem ein Labyrinth 4 für Fremdstoffe in Form von Ausnehmungen angeordnet. Das Gehäuseoberteil 2 weist außerdem Fixierzapfen 5 auf, die in Durchbohrungen 6 im Gehäuseunterteil 1 fixiert sind und Verdrehbewegungen verhindern. Zudem weist der Drehkodierschalter ein Betätigungselement 7 auf, welches vorzugsweise in MID-Technik ausgebildet ist. Zwischen Betätigungselement 7 und Gehäuseunterteil 1 sind Kontaktierungen 8 positioniert.

In Fig. 2 ist das Gehäuseoberteil 2 mit dem Betätigungselement 7 dargestellt. Im Betätigungselement 7 sind das Verrastprofil 3 sowie ein Betätigungsschlitz 9 und ein Richtungspfeil 10 angeordnet.

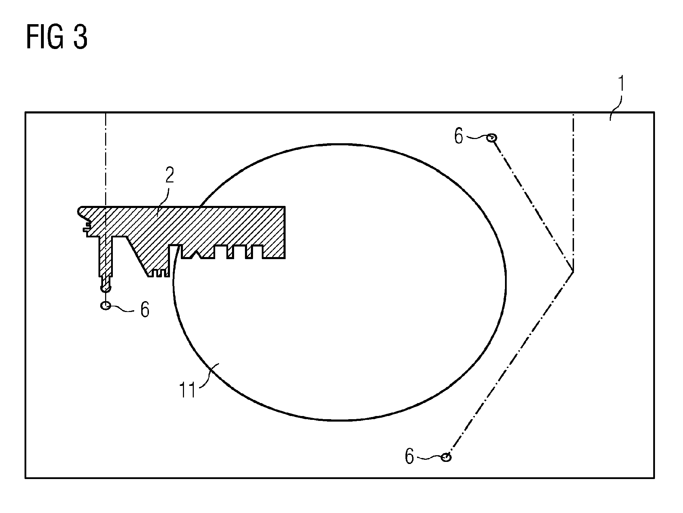

Fig. 3 zeigt das Gehäuseunterteil 1 mit einem Teil des Gehäuseoberteils 2. Aus Fig. 3 gehen die Durchbohrungen 6 für die Fixierzapfen 5 des Gehäuseoberteils 2 hervor sowie die Kodierstruktur 11, die als festes Layout-Element auf der Leiterplatte integriert ist.

Der erfindungsgemäße Drehkodierschalter zeichnet sich durch eine Reduzierung der Einzelteilkomplexität aus, in dem Einzelfunktionen in benachbarte, ohnehin vorhandene Bauteile verlagert werden, so dass die Anzahl der benötigten Einzelteile für den erfindungsgemäßen Drehkodierschalter reduziert werden konnte. Durch die Verwendung des CAD-Systems (Computer Added Design) können auf einfache Weise verschiedene Ausführungen mit anderen Kodierungen und Abstufungen umgesetzt werden. Das hier vorgestellte Konzept ist sowohl für stehende als auch liegende Varianten des Drehkodierschalters umsetzbar, wobei für die stehende Variante eine um 90° versetzte Zwischenplatine erforderlich ist. Durch das hier gewählte Design für die Kodiermatrix sind auch komplett neue Funktionen mit unterschiedlichen Kodierungen denkbar.

### Bezugszeichenliste

- 1: Gehäuseunterteil
- 2: Gehäuseobereil
- 3: Verrastprofil
- 4: Labyrinth
- 5: Fixierzapfen
- 6: Durchbohrung
- 7: Betätigungselement
- 8: Kontaktierung
- 9: Betätigungsschlitz
- 10: Richtungspfeil
- 11: Kodierstruktur

## Patentansprüche

1. Drehkodierschalter mit einer Anzahl von Schaltstufen, aufweisend ein Gehäuseoberteil (2) und ein Gehäuseunterteil (1),
**dadurch gekennzeichnet, dass** das Gehäuseunterteil (1) als Leiterplatten-Modul ausgebildet ist.

2. Drehkodierschalter nach Anspruch 1,
**dadurch gekennzeichnet, dass** die Bestückung des Leiterplatten-Moduls mit Kontaktstellen in Form von SMD-Elementen ausgebildet ist.

3. Drehkodierschalter nach Anspruch 1 oder 2,
**dadurch gekennzeichnet, dass** das Gehäuseoberteil (2) als Kunststoff-Spritzgieß-Modul ausgebildet ist mit einem Verrastprofil (3), um die unterschiedlichen Schaltstufen umzusetzen.

4. Drehkodierschalter nach Anspruch 3,
**dadurch gekennzeichnet, dass** das Verrastprofil (3) in 5,625°Schritten ausgebildet ist, um 64 Schaltstufen, elektrisch und taktil, umzusetzen.

5. Drehkodierschalter nach Anspruch 3 oder 4,
**dadurch gekennzeichnet, dass** im Gehäuseoberteil (2) ein Labyrinth (4) für Fremdstoffe angeordnet ist.

6. Drehkodierschalter nach einem der Ansprüche 3 bis 5,
**dadurch gekennzeichnet, dass** das Gehäuseoberteil (2) zur sicheren Fixierung Fixierzapfen (5) aufweist.

7. Drehkodierschalter nach einem der Ansprüche 1 bis 6,
**dadurch gekennzeichnet, dass** der Drehkodierschalter ein Betätigungselement (7) aufweist, welches in MID-Technik ausgebildet ist.
